# EUROPÄISCHE PATENTSCHRIFT

(11) **EP 0 319 852 B1**
(45) Veröffentlichungstag und Bekanntmachung des Hinweises auf die Patenterteilung: **16.03.1994**
(21) Anmeldenummer: 88120118.0
(22) Anmeldetag: 02.12.1988
(51) Int. Cl.: H01S 3/103, H01S 3/096, H04B 10/14

(54) **Schaltungsanordnung zur Modulation eines Halbleiter-Injektionslasers für die optische Nachrichtenübertragung**
Circuitry for the modulation of a semiconductor injection laser used in optical communication
Circuit électrique pour la modulation d'un laser à semi-conducteur à injection utilisé en communication optique

(30) Priorität: 05.12.1987 DE 3741305
(43) Veröffentlichungstag der Anmeldung: 14.06.1989
(73) Patentinhaber: Alcatel SEL Aktiengesellschaft, D-70435 Stuttgart (DE); ALCATEL N.V., NL-1077 XX Amsterdam (NL)
(72) Erfinder: Wedding, Berthold, Dr., D-4280 Borken 1 (DE)
(74) Vertreter: Graf, Georg Hugo, Dipl.-Ing.

(56) Entgegenhaltungen:
- DE-A- 3 307 309
- US-A- 3 711 740
- I.E.E. PROCEEDINGS-J/OPTOELECTRONICS, Band 133, Nr. 2, Teil J, April 1986, Seiten 155-162, Stevenage, Herts, GB; L. BICKERS et al.: "Reduction of transient laser chirp in 1.5 mum DFB lasers by shaping the modulation pulse"
- THE TRANSACTIONS OF THE IECE OF JAPAN, Band E 59, Nr. 1, Januar 1976, Seiten 1-8, Tokyo, JP; Y. SUEMATSU et al.: "High speed pulse modulation of injection lasers at non-bias condition"
- PROCEEDINGS OF THE IEEE, Band 62, Nr. 8, August 1974, Seiten 1176-1177, New York, US; T.P. LEE et al.: "Charge storage in injection lasers and its effect on high-speed pulse modulation of laser diode"

## Beschreibung

Die Erfindung betrifft eine Schaltungsanordnung nach dem Oberbegriff des Patentanspruchs.

Bei der digitalen Modulation von Signalen können bei hohen Bitraten die folgenden, für die optische Nachrichtenübertragung unerwünschten Effekte auftreten:

Aufgrund der Phasenbeziehung zwischen Photonendichte und Elektronendichte weist das optische Signal nach der ansteigenden Flanke gedämpfte Schwingungen auf.

Dadurch kommt es zu einer Linienverbreiterung der ausgesandten Strahlung.

Durch eine Schaltungsanordnung, die die Impulse in zwei Stufen ansteigen läßt, werden die Schwingungen unterdrückt und die Linienverbreiterung wird reduziert.

Eine solche Schaltungsanordung ist in der Veröffentlichung von L. Bickers, et al, "Reduction of transient laser chirp in 1.5 µm DFB lasers by shaping the modulation pulse", I.E.E. Proceedings-J/Optoelectronics, Vol. 133, No. 2, Part J, April 1986, pp. 155-162 beschrieben.

Desweiteren bestehen noch folgende Probleme:
Die optischen Ausgangsimpulse des Lasers weisen in Abhängigkeit von der Impulsfolge des Eingangssignals verschieden große Amplituden auf (Mustereffekt). Ein nach einer "0" (kein Spannungsimpuls am Lasereingang) folgendes "1"-Ausgangssignal ist kleiner, als wenn unmittelbar vorher eine "1" moduliert wurde. Außerdem kommt das optische Signal der Rechteckform viel weniger nahe als das elektrische. Insbesondere die abfallende Flanke ist viel flacher als die des elektrischen Signals.

Es ist eine Schaltungsanordnung bekannt, mit der diese Effekte weitestgehend unterdrückt werden, wenn ein Unterschwinger an die abfallende Flanke jedes Impulses angefügt wird.

Sie ist bekannt aus der Veröffentlichung von Y. Suematsu, et al, "High Speed Pulse Modulation Injection Lasers at Non-Bias Condition", Transactions of the IECE of Japan, Vol. E 59, No. 1, January 1976, pp. 1-8.

Der Erfindung liegt die Aufgabe zugrunde, eine geeignete Schaltungsanordnung anzugeben, die jeden elektrischen Impuls so vorverzerrt, daß er die Verzerrung kompensiert, die der Laser hervorruft.

Die Aufgabe wird gelöst wie im Patentanspruch angegeben.

Ein Vorteil der Erfindung ist es, daß kein Diskriminator zum Erkennen der Bitfolge benötigt wird, da jeder Impuls unabhängig von dem vorgehenden vorverzerrt wird und auch sehr hohe Impulsfrequenzen verarbeitet werden können.

Weitere Vorteile sind, daß auch die übrigen oben genannten Effekte weitestgehend unterdrückt werden. Dabei bewirkt der Unterschwinger, der an die abfallende Flanke jedes Impulses angefügt wird, daß der Mustereffekt nicht mehr auftritt und eine genügende Flankensteilheit erreicht wird. Durch die Vorstufe des Impulses werden die gedämpften Schwingungen und damit die Linienverbreiterungen unterdrückt.

Die Erfindung wird nun anhand der Zeichnungen beispielsweise erläutert. Es zeigen:
- Fig. 1: die Form eines vorverzerrten Impulses im Vergleich zum Eingangsimpuls und
- Fig. 2: eine erfindungsgemäße Vorverzerrer-Schaltung.

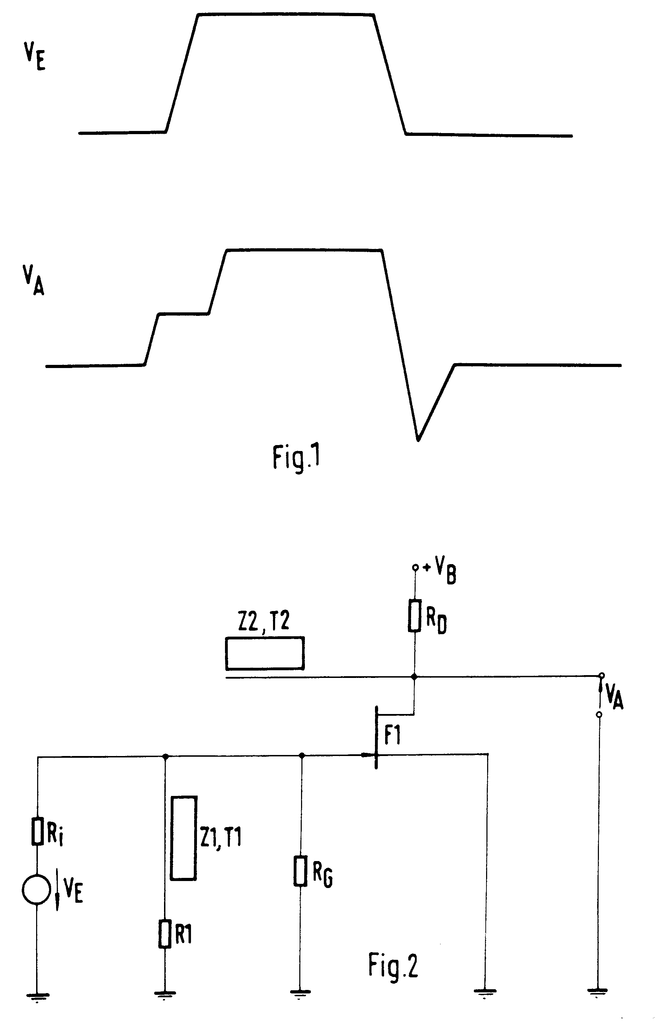

Fig. 1 zeigt den rechteckförmigen Eingangsimpuls V_{E} (oben) und den vorverzerrten Impuls (unten), bestehend aus einer Vorstufe, einem konstanten Bereich und einem Unterschwinger an der abfallenden Flanke.

Der erfindungsgemäßen Schaltung nach Fig. 2 liegt die Sourceschaltung eines Feldeffekttransistors F1 zugrunde, wie sie sich etwa aus U. Tietze, Ch. Schenk, Halbleiter-Schaltungstechnik, Berlin, 8. Aufl. 1986, S. 89, entnehmen läßt.

Sie besteht aus einem Feldeffekttransistor F1, dessen Drain-Anschluß über einen Drain-Widerstand R_{D} mit dem Positiv-Pol einer Spannungsquelle und dessen Source-Anschluß mit dem Bezugspotential (Masse) verbunden ist. Zwischen dem Gate-Anschluß des Feldeffekttransistors F1 und dem Bezugspotential liegt eine Signalquelle mit einem Innenwiderstand Rᵢ, deren Ausgangsspannung V_{E} die Eingangsspannung der Schaltung ist. Als Ausgangsspannung der Schaltung wird eine Spannung V_{A} gegen Bezugspotential am Drain-Anschluß abgenommen.

Eine Serienschaltung aus einem Wellenleiter Z1, T1 mit einem vorgegebenen Wellenwiderstand Z1 und einer vorgegebenen Verzögerungszeit T1 und einem ohmschen Widerstand R1 liegt zwischen dem Gate-Anschluß des Feldeffekttransistors F1 und dem Bezugspotential (Masse), wobei der Widerstand R1 zwischen den Wellenleiter und das Bezugspotential geschaltet ist. Parallel zu dieser Serienschaltung ist ein ohmscher Widerstand R_{G} geschaltet.

An den Drain-Anschluß des Feldeffekttransistors F1 ist ein zweiter Wellenleiter Z2, T2 angeschlossen. Sein Wellenwiderstand Z2 und seine Verzögerungszeit T2 sind ebenfalls vorgegeben. Der Wellenleiter hat ein offenes Ende, an dem die Wellen reflektiert werden.

Zweckmäßigerweise sind die Wellenleiter als Mikrostreifenleitungen realisiert, auch Koaxialleitungen sind geeignet.

Durch das Netzwerk aus dem Wellenleiter Z1, T1 und den Widerständen R1 und R_{G} wird die Eingangsspannung V_{E} verformt. Am Gate-Anschluß des Feldeffekttransistors F1 liegt daher eine Spannung an, die aus einem zu V_{E} proportionalen Anteil besteht, dem ein näherungsweise zur zeitlichen Ableitung von V_{E} proportionaler Anteil überlagert ist. An dieser Stelle besteht der Impuls aus einem Überschwinger, einem konstanten Bereich und einem Unterschwinger. Der Überschwinger der Ausgangsspannung V_{A} wird durch geeignete Wahl des Arbeitspunktes des Feldeffekttransistors F1 unterdrückt. Durch den zweiten Wellenleiter Z2, T2 wird nun noch die Vorstufe des Impulses erzeugt. Damit liegt am Ausgang des Vorverzerrers eine Spannung V_{A} an, deren Verlauf in Fig. 1 im unteren Teil gezeigt ist.

## Patentansprüche

1. Schaltungsanordung zur Modulation eines Halbleiter-Injektionslasers, mit einem Vorverzerrer, der ein rechteckförmige Impulse enthaltendes elektrisches Eingangssignal zur Erzeugung eines optischen Signals mit rechteckförmigen Impulsen derart vorverzerrt, daß der Vorverzerrer jeden Ausgangsimpuls in zwei Stufen anssteigen läßt,
**dadurch gekennzeichnet**,
daß der Vorverzerrer an der abfallenden Impulsflanke einen Unterschwinger erzeugt und eine Feldeffekttransistor-Sourceschaltung enthält,
daß der Gate-Anschluß des Feldeffekttransistors (F1) über einen Wellenleiter (Z1, T1) mit einem vorgegebenen Wellenwiderstand (Z1) und einer vorgegebenen Verzögerungszeit (T1) in Serie mit einem ohmschen Widerstand (R1) mit dem Bezugspotential verbunden ist, wobei der ohmsche Widerstand (R1) zwischen den Wellenleiter und das Bezugspotential geschaltet ist,
daß der Gate-Anschluß über einen zweiten ohmschen Widerstand (R_{G}) mit dem Bezugspotential verbunden ist und
daß an den Drain-Anschluß des Feldeffekttransistors (F1) ein zweiter Wellenleiter (Z2, T2) mit einem vorgegebenen Wellenwiderstand (Z2) und einer vorgegebenen Verzögerungszeit (T2) angeschlossen ist, dessen Ende offen ist.

## Claims

1. A circuit arrangement for modulating an injection laser, comprising a predistorter which predistorts an electric input signal containing rectangular pulses for the generation of an optical signal with rectangular pulses such that the predistorter causes each output to rise to its full amplitude in two steps,
**characterized in**
that the predistorter produces an undershoot at the trailing pulse edge and includes a field-effect transistor (F1) in a common-source configuration, that the gate of the field-effect transistor (F1) is grounded through a waveguide (Z1, T1) having a predetermined characteristic impedance (Z1) and a predetermined delay (T1) in series with a resistor (R1), with the resistor (R1) connected between the waveguide and ground, that the gate is grounded through a second resistor (R_{G}), and that the drain of the field-effect transistor (F1) is connected to a second waveguide (Z2, T2) having a predetermined characteristic impedance (Z2) and a predetermined delay (T2) whose end is open.

## Revendications

1. Dispositif de circuit pour moduler un laser à injection à semi-conducteur, comportant un organe de prédistorsion qui, pour produire un signal optique à impulsions rectangulaires, fait subir à un signal électrique d'entrée contenant des impulsions rectangulaires une prédistorsion de façon telle que l'organe de prédistorsion peut faire croître chaque impulsion d'entrée en deux échelons,
dispositif caractérisé,
par le fait que l'organe de prédistorsion produit sur le flanc décroissant de l'impulsion une sous-modulation et qu'il contient un circuit de source de transistor à effet de champ,
par le fait que la borne de grille du transistor à effet de champ (F1) est reliée au potentiel de référence par l'intermédiaire d'un guide d'ondes (Z1, T1), d'impédance caractéristique (Z1) prescrite et de retard (T1) prescrit, en série avec une résistance ohmique (R1), la résistance ohmique (R1) étant montée entre le guide d'ondes et le potentiel de référence,
par le fait que la borne de grille est reliée avec le potentiel de référence par l'intermédiaire d'une seconde résistance ohmique (R_{G}) et
par le fait qu'à la borne de drain du transistor à effet de champ (F1) est relié un second guide d'ondes (Z2, T2) d'impédance caractéristique (Z2) prescrite et de retard (Z2) prescrit et dont l'extrémité est ouverte.
